# EUROPEAN PATENT APPLICATION

(11) **EP 4 579 532 A1**
(43) Date of publication of application: **02.07.2025**
(21) Application number: 24223476.3
(22) Date of filing: 27.12.2024
(51) Int. Cl.: G06N 3/063, G11C 11/54

(54) **MEMORY DEVICE WITH ADDRESS GENERATOR AND OPERATING METHOD THEREOF**

(30) Priority: 29.12.2023 KR 20230196766
(71) Applicant: Samsung Electronics Co., Ltd., Suwon-si, Gyeonggi-do 16677 (KR)
(72) Inventor: KIM, Hyunsoo, 16678 Suwon-si, Gyeonggi-do (KR); KIM, Junkyum, 16678 Suwon-si, Gyeonggi-do (KR); CHA, Sanghoon, 16678 Suwon-si, Gyeonggi-do (KR)
(74) Representative: Grünecker Patent- und Rechtsanwälte PartG mbB

(57) **Abstract**

A memory device includes a memory array, an address generator, a data register, and a processing unit. The address generator is configured to receive an instruction and a base address of the instruction from a host, and sequentially generate target addresses for performing operations of the instruction by sequentially adding offsets to the base address. The data register is configured to store data values corresponding to one or more of the target addresses. The processing unit is configured to perform one or more of the operations of the instruction based on the data values.

## Description

### 1. Technical Field

The embodiments below are directed to a memory device with an address generator and an operating method thereof.

### 2. Discussion of Related Art

A vector matrix multiplication operation, also known as a multiply and accumulate (MAC) operation, may be used in various applications. For example, the MAC operation may be performed during machine learning and used to authenticate a neural network including multiple layers. An input signal for images, bytestreams, or other data sets may be used to generate an input vector that is to be applied to the neural network. The input vector may be multiplied by a weight, and an output vector may be obtained based on a result of one or more MAC operations performed on the weighted input vector by a layer of the neural network. The output vector may be provided as an input vector to a subsequent layer of the neural network. Since the MAC operation may be repeatedly used in multiple layers of the neural network, processing performance of the neural network may be mainly determined by the performance of the MAC operation.

Processing-in memory (PIM) refers to a specific type of architecture where a processing element is placed closer to memory or integrated within the memory itself. This aims to reduce the bottleneck caused by data movement between a central processing unit and the memory.

Since the processing performance of a neural network is highly dependent on MAC operations, it may be possible increase this performance if MAC operations can be implemented using PIM.

### SUMMARY

The invention is what is claimed in the independent claims. Preferred embodiments are specified in the dependent claims.

According to an embodiment, a memory device includes a memory array, an address generator, a data register, and a processing unit. The address generator is configured to receive an instruction and a base address of the instruction from a host and sequentially generate target addresses for performing operations of the instruction by sequentially adding offsets to the base address. The data register is configured to store data values corresponding to one or more of the target addresses. The processing unit is configured to perform one or more of the operations of the instruction based on the data values.

According to an embodiment, an electronic device includes a host, an address generator, a data register, and a processing unit. The address generator is configured to receive an instruction and a base address of the instruction from the host and sequentially generate target addresses for performing operations of the instruction by sequentially adding offsets to the base address. The data register is configured to store data values corresponding to one or more of the target addresses. The processing unit configured to perform one or more of the operations of the instruction based on the data values.

According to an embodiment, an operating method of a memory device includes receiving an instruction and a base address of the instruction from a host, sequentially generating target addresses for performing operations of the instruction by sequentially adding offsets to the base address, storing data values corresponding to one or more of the target addresses, and performing one or more of the operations of the instruction based on the data values.

According to an embodiment, a memory device includes a processing unit and an address generator. The address generator includes a first counter, a second counter, an adder and a selector. The selector is configured to receive an instruction and a base address, increase a first count value of the first counter and provide the first count value as an offset to the adder when the instruction is for storing data in the memory device, and configured to increase a second count value of the second counter and provide the second count value as the offset to the adder when the instruction is for the processing unit to perform an operation on data in the memory device. The adder is configured to generate a target memory address to access the memory device by adding the offset to the base address. The address generator may further include a third counter, where the selector increases the first count value when the data is to be stored in a first region of the memory device, and the selector increases a third count value of the third counter and provides the third count value as an offset to the adder when the data to be stored in a second region of the memory device different from the first region.

### BRIEF DESCRIPTION OF THE DRAWINGS

These and/or other aspects and features of the inventive concept will become apparent and more readily appreciated from the following description of embodiments, taken in conjunction with the accompanying drawings of which:
FIG. 1 is a diagram exemplarily illustrating a configuration of a memory device, according to an embodiment;
FIG. 2Ais a diagram exemplarily illustrating a configuration of an address generator of a memory device, according to an embodiment;
FIG. 2B is a diagram exemplarily illustrating a configuration of a counter block of an address generator, according to an embodiment;
FIG. 3 is a diagram exemplarily illustrating respective changes in processing times of a host and a memory device resulting from address generation by a memory device, according to an embodiment;
FIGS. 4A to 4C are diagrams exemplarily illustrating an instruction processing process of a memory device, according to an embodiment;
FIG. 5 is a diagram exemplarily illustrating a mapping relationship among a weight, an input feature, and an output feature, according to an embodiment;
FIGS. 6A, 6C, 6E, and 6G are diagrams exemplarily illustrating a process of processing a multiply and accumulate (MAC) operation, according to an embodiment;
FIGS. 6B, 6D, 6F, and 6H are diagrams exemplarily illustrating subtiles of a weight, an input feature, and an output feature, respectively, used in the processing process of FIGS. 6A, 6C, 6E, and 6G, according to an embodiment;
FIG. 7 is a diagram exemplarily illustrating a configuration of an address generator when memory banks share a processing-in-memory (PIM) structure, according to an embodiment;
FIG. 8 is a flowchart exemplarily illustrating an operating method of a memory device, according to an embodiment; and
FIG. 9 is a diagram exemplarily illustrating a configuration of an electronic device, according to an embodiment.

### DETAILED DESCRIPTION

Embodiments will now be described more fully hereinafter with reference to the accompanying drawings. The same reference numbers may indicate the same components throughout the disclosure. Here, the embodiments are not construed as limited to the disclosure and should be understood to include all changes, equivalents, and replacements within the idea and the technical scope of the disclosure.

It should be noted that if it is described that one component is "connected", "coupled", or "joined" to another component, a third component may be "connected", "coupled", and "joined" between the first and second components, although the first component may be directly connected, coupled, or joined to the second component.

As used herein, the singular forms "a", "an", and "the" include the plural forms as well, unless the context clearly indicates otherwise.

As used herein, "at least one of A and B", "at least one of A, B, or C," and the like, each of which may include any one of the items listed together in the corresponding one of the phrases, or all possible combinations thereof.

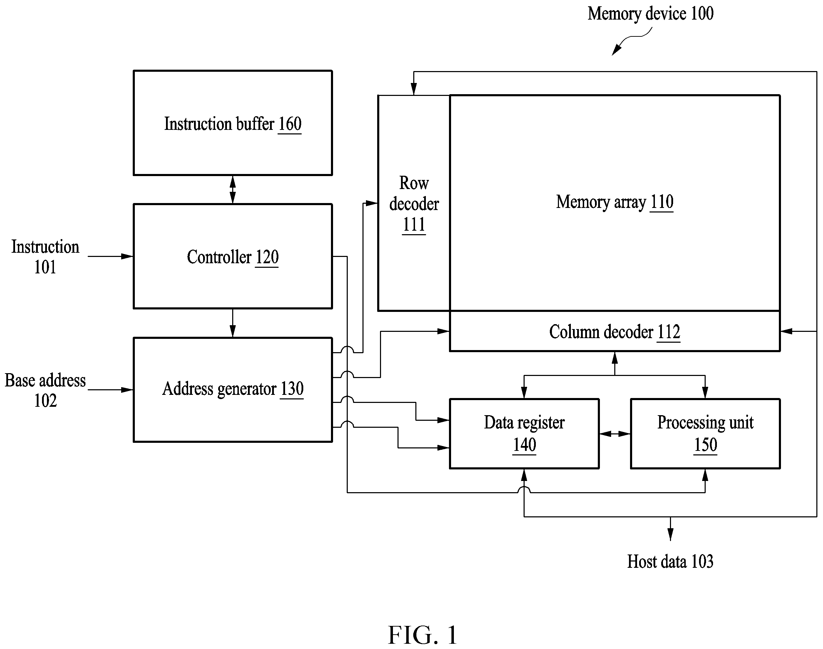

FIG. 1 is a diagram exemplarily illustrating a configuration of a memory device, according to an embodiment. Referring to FIG. 1, a memory device 100 may include a memory array 110, a row decoder 111 (e.g., a first decoder circuit), a column decoder 112 (e.g., a second decoder circuit), an address generator 130, a data register 140, a processing unit 150 (e.g., a processor), and an instruction buffer 160.

The memory array 110 may store data. A memory address may be needed to access the memory array 110. The memory address may be decoded using the row decoder 111 and the column decoder 112. The memory address may include row information and column information. The row information may be decoded by the row decoder 111, and the column information may be decoded by the column decoder 112.

The processing unit 150 may be a processing-in-memory functional processing unit (PIM FPU). The processing unit 150 may perform an operation. For example, the operation may include a multiply and accumulate (MAC) operation. The processing unit 150 may include operation logic used to perform an operation. The operation logic may temporarily store data for operations, perform an operation using the data for operations, and generate an operation result. The operation logic may correspond to a hardware logic (e.g., a logic circuit). The data register 140 may provide a memory space to temporarily store data used for operations of the processing unit 150. The processing unit 150 may perform an operation using the data register 140 to generate a final operation result and store the final operation result in the memory array 110. The host may store host data 103 in the memory array 110 and the data register 140. The host may store the host data 103 directly in the memory array 110 or directly in the data register 140.

The memory device 100 may have a PIM structure including the processing unit 150. The PIM structure may refer to the structure or operation of memory with a computational function. However, embodiments are not limited thereto since other structures may be used such as near-memory processing (NMP) and in-memory processing instead of PIM. In certain systems, a bottleneck may occur between the host and memory. In particular, in memory-intensive applications with high memory usage, data transmission between the host and the memory may account for most of the delay in overall system performance. The memory device 100 may internally process operations using the PIM structure. For example, in the PIM structure, an in-memory acceleration method based on bank-level parallelism may be provided.

The processing unit 150 may not perform operations while the host is computing memory addresses used for an operation of the processing unit 150, which may reduce utilization of the PIM structure and reduce performance. In addition, when additional elements such as an address-align mode or column-aligned mode are used to prevent the order in which the memory addresses computed by the host are transferred to the memory device 100 from being different from the actual operation order, the additional elements may cause performance degradation. For example, the host may correspond to a central processing unit (CPU) or a graphics processing unit (GPU), and the memory device 100 may correspond to a dynamic random-access memory (DRAM), but is not limited thereto.

According to an embodiment, target addresses for performing operations of an instruction 101 may be generated by the address generator 130 of the memory device 100. When target addresses are generated internally in the memory device 100 by the address generator 130 due to receipt of the base address 102 from the host, the utilization of the PIM structure may increase, and performance may increase. Additionally, when the target addresses are generated internally in the memory device 100, alignment issues should not occur.

More specifically, the controller 120 may receive the instruction 101 from the host. The address generator 130 may receive the base address 102 of the instruction 101 from the host, and sequentially generate target addresses for performing operations of the instruction 101 by sequentially adding offsets to the base address 102. The offsets may have a predetermined interval. The address generator 130 may sequentially add the offsets to the base address 102 using the offsets having a predetermined interval for the base address 102. The predetermined interval may be fixed, and the offsets may have the same interval. A memory address of the memory array 110 may be specified using the base address 102 and an offset. The memory address specified using the base address 102 and the offset may be referred to as the target address. The data register 140 may store data values (e.g., input elements, weight elements, or output elements) corresponding to one or more of the target addresses. The processing unit 150 may perform one or more of the operations of the instruction 101 based on the data values. The base address 102 may include a base row address and a base column address.

The instruction 101 may be a direct instruction for directly controlling the processing unit 150 or an indirect instruction for indirectly controlling the processing unit 150. When a direct instruction is received, the controller 120 may control the processing unit 150 to perform the operations of the instruction 101. The instruction buffer 160 may store auxiliary instructions related to indirect instructions. When an indirect instruction is received, the controller 120 may control the processing unit 150 based on auxiliary instructions located in the instruction buffer 160, which are related to the indirect instruction. The controller 120 may load the auxiliary instructions related to the indirect instruction from the instruction buffer 160, and control the processing unit 150 to perform operations of the auxiliary instructions.

For example, the instruction 101 may include a store instruction for storing data or auxiliary instructions in the memory array 110, the data register 140, the processing unit 150, or the instruction buffer 160, a load instruction for loading data or auxiliary instructions from the memory array 110, the data register 140, the processing unit 150, or the instruction buffer 160, an operation instruction (e.g., a MAC operation instruction) for performing an operation using data, and the like. For example, the operation instruction may be configured using auxiliary instructions. However, the type of instruction 101 or the implementation form of the operation instruction is not limited thereto. The operation logic of the processing unit 150 may include a memory space for temporarily storing data for operations, and the memory space may be used for loading, storing, and operating by the instruction 101.

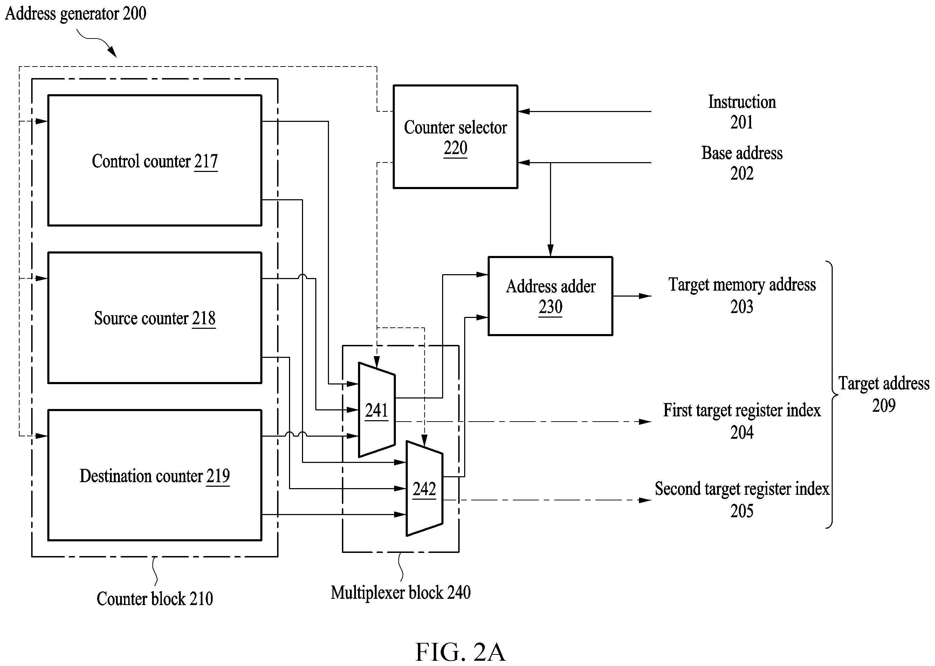

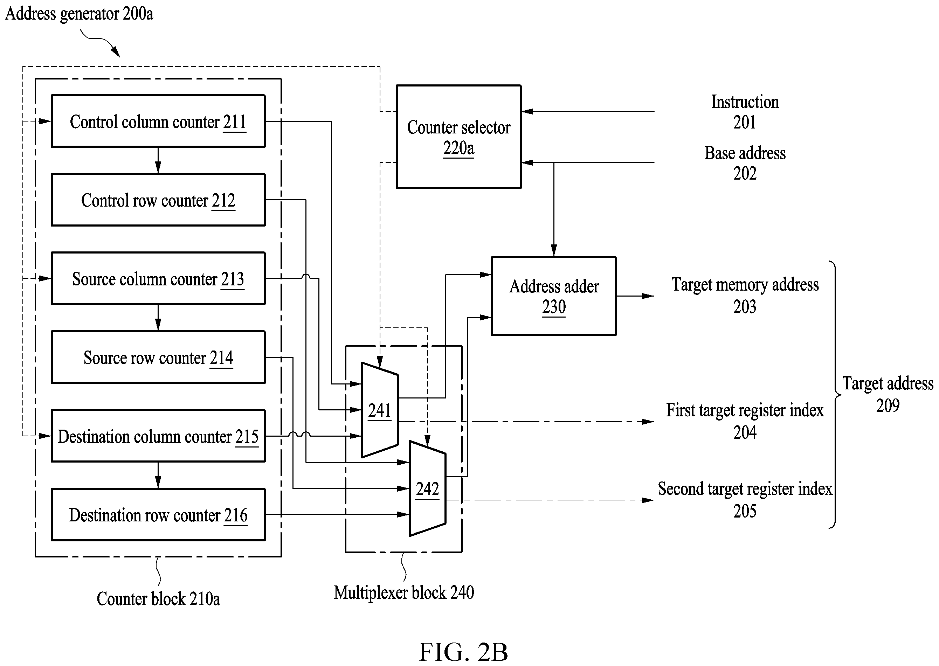

FIG. 2Ais a diagram exemplarily illustrating a configuration of an address generator of a memory device, according to an embodiment. Referring to FIG. 2, an address generator 200 may include a counter block 210 (e.g., a logic circuit) for generating offsets, a counter selector 220 (e.g., a selector circuit) for controlling the counter block 210, and an address adder 230 for generating a target memory address 203 by adding an offset to a base address 202 of an instruction 201. The address generator 200 may be used to implement the address generator 130 of FIG. 1. The base address 202 may correspond to the base address 102 of FIG. 1. The instruction 201 may correspond to the instruction 101 of FIG. 1. In an embodiment, the offset is the count value of a counter provided to the address adder 230.

The counter block 210 may include counters (e.g., a control counter 217, a source counter 218, and a destination counter 219). The control counter 217, the source counter 218, and the destination counter 219 may be selectively used based on the instruction 201 and/or the base address 202. The counter selector 220 may control the counter block 210 based on the instruction 201 and/or the base address 202. The counter selector 220 may select one of the counters 217 to 219 of the counter block 210 based on the type of instruction 201 and the location (e.g., a memory array or a register) indicated by the base address 202. For example, the counter selector 220 may control the control counter 217 to increase a count value of the control counter 217 when storing data (e.g., an input feature) in a data register, control the source counter 218 to increase a count value of the source counter 218 when performing an operation on data (e.g., a weight) in a memory array and/or the data (e.g., the input feature) in the data register using a processing unit, and control the destination counter 219 to increase a count value of the destination counter 219 when storing data (e.g., an output feature) in the memory array. In an embodiment, the control counter 217 enables the memory device 100 to store a multitude of data in multiple locations within the data register by only receiving a single address from the host without receiving multiple addresses or offset(s) from the host. In an embodiment, the source counter 218 enables the memory device 100 to perform an operation on data in multiple locations within the memory array or the data register without receiving multiple addresses or offset(s) from the host. In an embodiment, the destination counter 219 enables the memory device 100 to store data in multiple locations within the memory array without receiving multiple addresses or offset(s) from the host. The names and number of counters 217 to 219 such as control, source, and destination counters are examples and are not limited thereto. For example, if there are two control counters, the first control counter may be used for storing a multitude of data in multiple locations within a first region of the data register and the second control counter may be used for storing a multitude of data in multiple locations within a second other region of the data register. For example, if there are two source counters, the first source counter may be used for performing an operation on data in multiple locations within a first region of the memory array or the data register and the second source counter may be used for performing an operation on data in multiple locations within a second other region of the memory array or the data register. For example, if there are two destination counters, the first destination counter may be used to store data in multiple locations within a first region of the memory array and the second destination counter may be used to store data in multiple locations within a second other region of the memory array. The counters 217 to 219 may each include a column counter and a row counter. A count value of the column counter may be referred to as a column count value, and a count value of the row counter may be referred to as a row count value. The column count value may correspond to a column offset of the target memory address 203, and the row count value may correspond to a row offset of the target memory address 203.

The counters 217 to 219 may sequentially increase the count values based on control of the counter selector 220. The counter selector 220 may be controlled using a counter selection signal. The counters 217 to 219 may each sequentially increase one (e.g., the column counter value) of the column counter value and the row counter value to the maximum value by controlling one (e.g., the column counter) of the column counter and the row counter, and increase the other one (e.g., the row counter value) of the column counter value and the row counter value when one (e.g., the column counter value) of the column counter value and the row counter value reaches the maximum value. Which of the column counter value and the row counter value to increase first may be determined based on an address configuration of the memory array. If the address configuration of the memory array has a manner of increasing the column address first, the column counter value may be increased first. If the address configuration of the memory array increases the row address first, the row counter value may be increased first.

The address generator 200 may further include a multiplexer block 240. The multiplexer block 240 may include a column multiplexer 241 for selecting an output of one of the column counters of the counters 217 to 219 based on control of the counter selector 220 and a row multiplexer 242 for selecting an output of one of the row counters of the counters 217 to 219 based on control of the counter selector 220. The counter selector 220 may be controlled using a counter selection signal.

The column multiplexer 241 and the row multiplexer 242 may output the target memory address 203 or target register indexes 204 and 205 to generate a target address 209 based on control of the counter selector 220 based on the instruction 201, the base address 202, or a combination thereof. The data register of the memory device may include a first register group and a second register group. The first target register index 204 may be used to specify a register in the first register group, and the second target register index 205 may be used to specify a register in the second register group. However, the configuration of the data register and the configuration of the target register indexes 204 and 205 are not limited thereto.

Access to the memory array and access to registers may be synchronized based on the number of registers. The target register indexes 204 and 205 may be generated by extracting a number of bits that identify the number of registers in each register group of the data register from a least significant bit (LSB) of the output of the counter block 210 corresponding to an offset. For example, if the number of registers is "4", the "4" registers may be identified with "2" bits, and thus, "2" bits from the LSB may be used as the target register indexes 204 and 205.

As described above, the address generator 200 may generate the target address 209 based on the instruction 201 and the base address 202. The target addresses may be sequentially generated as offsets corresponding to the outputs of the counter block 210 according to the increase in the count values that are sequentially added to the base address 202. The offsets and the target addresses may have a predetermined interval corresponding to an interval of neighboring values of the column count values. For example, if the interval of the column count values is "4", the offsets and the target addresses may have an interval of "4". Since the target addresses are generated on the memory device side if the instruction 201 and the base address 202 are given, a PIM operation using the processing unit of the memory device may be performed without computing the target addresses of the base address 202 by the host.

FIG. 2B is a diagram exemplarily illustrating a configuration of a counter block of an address generator, according to an embodiment. Referring to FIG. 2B, a counter block 210a of an address generator 200a may include a control column counter 211, a control row counter 212, a source column counter 213, a source row counter 214, a destination column counter 215, and a destination row counter 216. The address generator 200a may be used to implement the address generator 130 of FIG. 1. The control column counter 211 and the control row counter 212 may correspond to the column counter and the row counter of the control counter 217 of FIG. 2A. The source column counter 213 and the source row counter 214 may correspond to the column counter and the row counter of the source counter 218 of FIG. 2A. The destination column counter 215 and the destination row counter 216 may correspond to the column counter and the row counter of the destination counter 219 of FIG. 2A.

The counter selector 220a may control the counter block 210a based on the instruction 201 and/or the base address 202. The counter block 210a may include a column counter group including the column counters 211, 213, and 215 and a row counter group including the row counters 212, 214, and 216. The counter selector 220a may first control one of the column counter group and the row counter group. FIG. 2B corresponds to an example of first controlling the column counter group, but is not limited thereto. In the example of FIG. 2B, the counter selector 220a may receive only a base row address of the base address 202. The counter selector 220a may select one of the counters 211 to 216 of the counter block 210 based on the type of instruction 201 and the location (e.g., a memory array or a register) indicated by the base address 202.

For example, the counter selector 220a may control the control column counter 211 to increase a count value of the control column counter 211 when storing data (e.g., an input feature) in a data register, control the source column counter 213 to increase a count value of the source column counter 213 when performing an operation on data (e.g., a weight) in a memory array and/or the data (e.g., the input feature) in the data register using a processing unit, and control the destination column counter 215 to increase a count value of the destination column counter 215 when storing data (e.g., an output feature) in the memory array.

The column counters 211, 213, and 215 of the column counter group may sequentially increase the column count values based on control of the counter selector 220a. The counter selector 220a may be controlled using a counter selection signal. The row counters 212, 214, and 216 of the row counter group may increase row count values when the column count values increase to the maximum values. The column counters 211, 213, and 215 may initialize the column count values when the column count values increase to the maximum values. For example, the initializing of the column count values may be performed by setting the column count values to zero.

A column count value and a row count value may be increased by a predetermined interval. For example, the column count value may correspond to the size of subtiles of a tile, and the row count value may correspond to a value obtained by multiplying the size of the subtiles by the number of subtiles belonging to a single row of the memory array. For example, the predetermined interval for the column count value may correspond to the size and the predetermined interval for the row count value may correspond to the value.

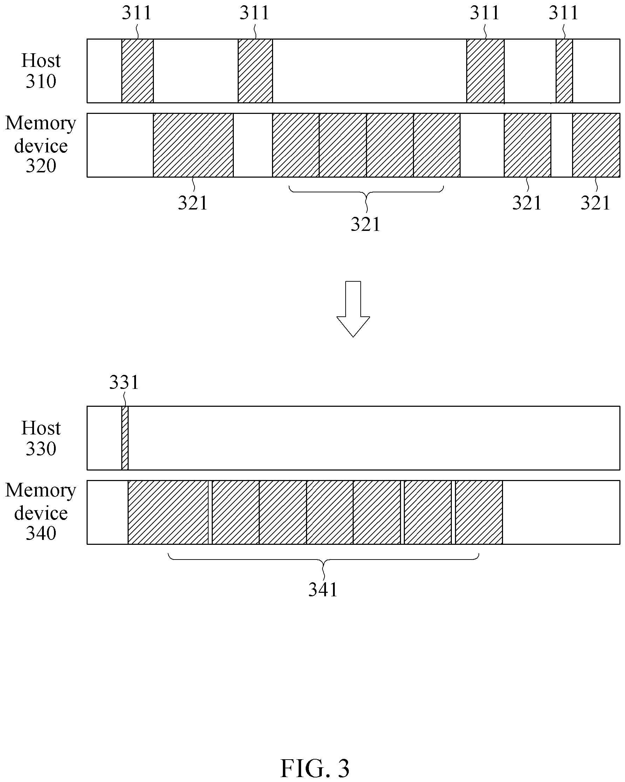

FIG. 3 is a diagram exemplarily illustrating respective changes in processing times of a host and a memory device resulting from address generation by a memory device, according to an embodiment. Referring to FIG. 3, an existing host 310 performs processing 311 to generate memory addresses overall. Since memory addresses are needed to perform a data operation of an existing memory device 320, a delay related to processing 311 by the existing host 310 may occur in processing 321 for the data operation by the existing memory device 320. A host 330 according to an embodiment performs processing 331 to generate a base address among memory addresses. A memory device 340 according to the embodiment generates memory addresses by itself based on the base address and thus, may perform processing 341 for a data operation in a state in which a delay related to an additional operation of the host 330 to generate the memory addresses is eliminated.

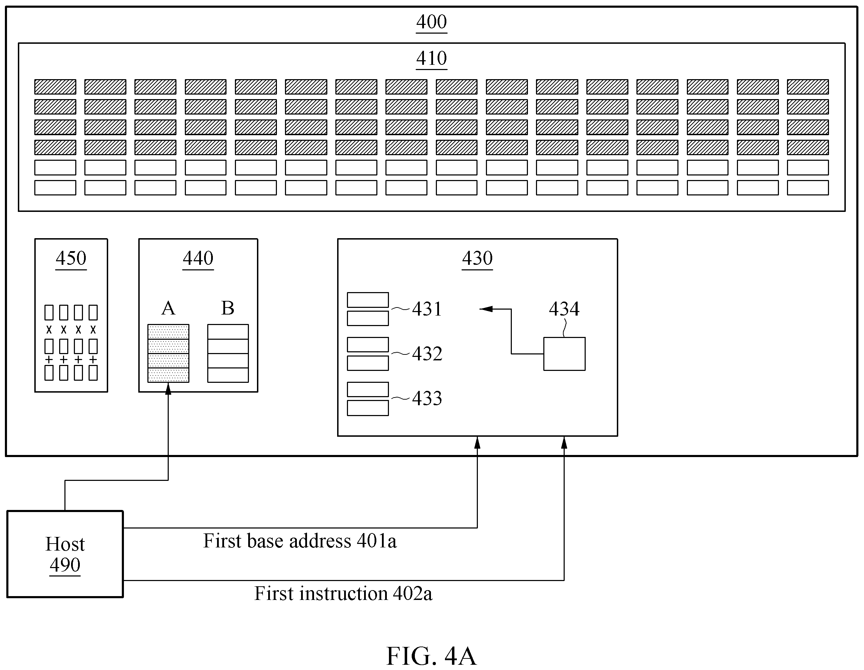

FIGS. 4A to 4C are diagrams exemplarily illustrating an instruction processing process of a memory device, according to an embodiment. Referring to FIGS. 4A to 4C, a memory bank 400 may include a memory array 410, an address generator 430, a data register 440, and a processing unit 450.

Referring to FIG. 4A, a counter selector 434 of an address generator 430 may receive, from a host 490, a first instruction 402a for storing subtiles of an input feature tile of an input feature in a first register group A of the data register 440 and a first base address 401a of the first instruction 402a indicating a starting index of the first register group A, and control a first counter group 431 of a counter block to generate offsets of the first base address 401a. The first instruction 402a may be a store instruction. The first counter group 431 may include a control column counter and a control row counter. The counter selector 434 may control the control column counter.

When first target addresses (e.g., target register indexes) of the first register group A are generated by adding the offsets of the first base address 401a to the first base address 401a by an address adder of the address generator 430, the first register group A may store the subtiles of the first input feature tile in the first register group Abased on the first target addresses.

The subtiles of the first input feature tile may be stored in the first register group A by the first instruction 402a without the host 490 performing an operation to generate the offsets from the first base address. For example, the host 490 may provide the first instruction 402a to the address generator 430 N times without specifying offsets, and in this process, the subfiles of the first input feature tile may be stored N times from the first base address 401a to N*M-1. Here, M may denote the interval of count values.

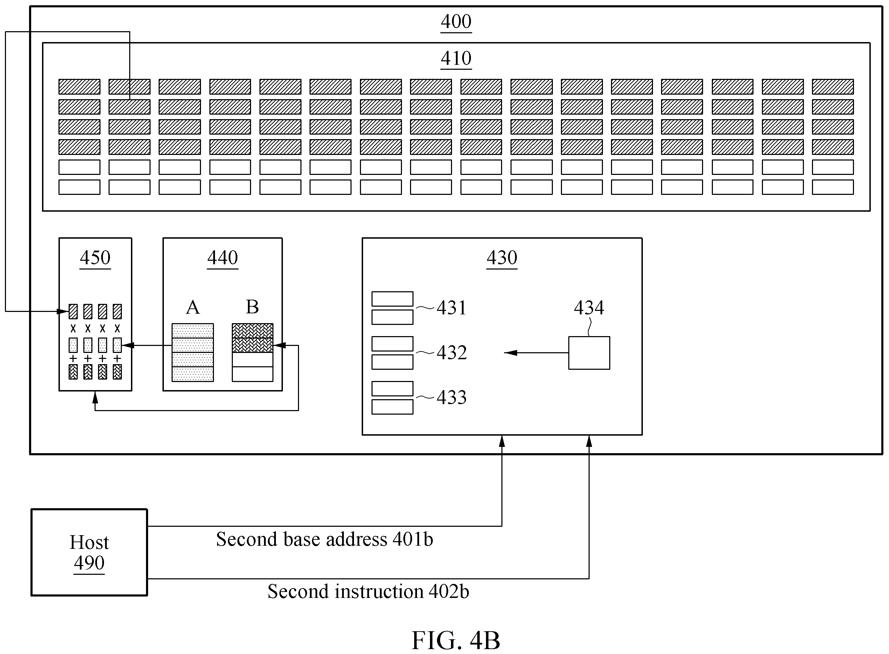

Referring to FIG. 4B, the counter selector 434 may receive a second instruction 402b for storing subfiles of a first weight tile of a weight in a data space of the processing unit 450 and a second base address 401b of the second instruction 402b indicating a starting address of the memory array 410 in which the weight is stored, and control a second counter group 432 of the counter block to generate offsets of the second base address 401b. The second instruction 402b may be an operation instruction (e.g., a MAC operation instruction) or a load instruction for loading auxiliary instructions for an operation from an instruction buffer. The second counter group 432 may include a source column counter and a source row counter. The counter selector 434 may control the source column counter.

When second target addresses (e.g., target memory addresses) of the memory array 410 are generated by adding the offsets of the second base address 401b to the second base address 401b by the address adder of the address generator 430, the processing unit 450 may sequentially perform operations on the subtiles of the first input feature tile loaded to the data space of the processing unit 450 based on the first target addresses and the subtiles of the first weight tile loaded to the data space of the processing unit 450 based on the second target addresses to generate operation results, and generate subfiles of a first output feature tile by accumulating the operation results. The operation results may be accumulated using a second register group B.

Operations on the subfiles of the first weight tile and the subfiles of the first input feature tile may be performed by the second instruction 402b without the host 490 performing an operation to generate the offsets of the second base address 401b. For example, the host 490 may provide the second instruction 402b to the address generator 430 N times without specifying offsets, and in this process, operations on the subtiles of the first weight tile and the subtiles of the first input feature tile may be performed N times. At this time, the subtiles of the first weight tile may be loaded N times from the second base address 401b to N*M-1. The subfiles of the first input feature tile may be loaded N times from the first register group A using lower bits of the target memory addresses of the subtiles of the first weight tile.

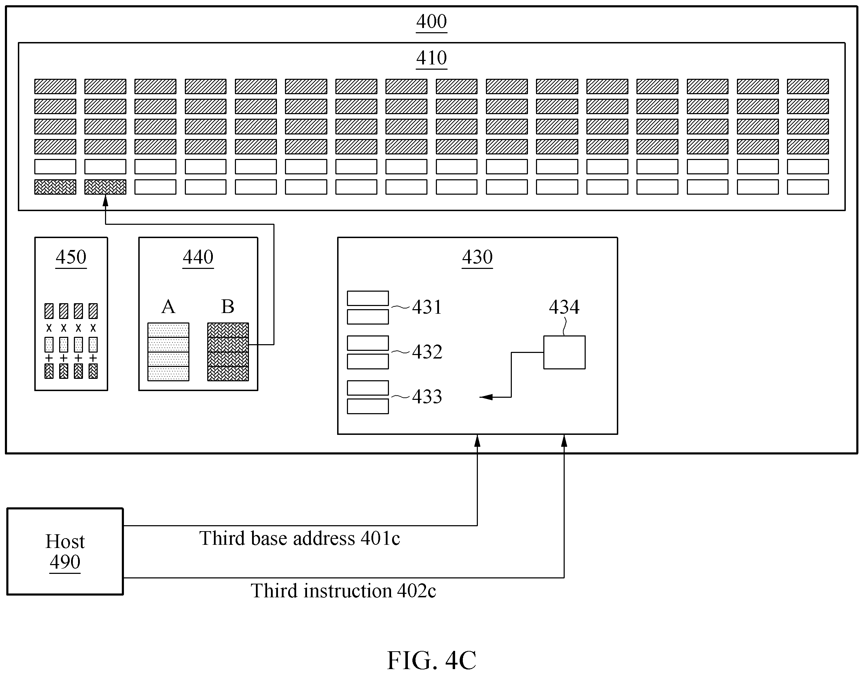

Referring to FIG. 4C, the counter selector 434 may receive a third instruction 402c for storing, in the memory array 410, subtiles of the first output feature tile stored in the second register group B of the data register 440, and a third base address 401c of the third instruction 402c indicating a starting address of the memory array 410 to store the subtiles of the first output feature tile, and control a third counter group 433 of the counter block to generate offsets from the third base address 401c. The third counter group 433 may include a destination column counter and a destination row counter. The counter selector 434 may control the destination column counter.

When third target addresses (e.g., target memory addresses) of the memory array 410 are generated by adding the offsets of the third base address 401c to the third base address 401c by the address adder of the address generator 430, the subfiles of the first output feature tile may be stored in the memory array 410 based on the third target addresses.

The subtiles of the first output feature tile may be stored in the memory array 410 by the third instruction 402c without the host 490 performing an operation to generate the offsets of the third base address 401c. For example, the host 490 may provide the third instruction 402c to the address generator 430 N times without specifying offsets, and in this process, the subfiles of the first output feature tile may be stored N times from the third base address 401c to N*M-1. The subtiles of the first output feature tile may be loaded N times from the second register group B using lower bits of the target memory addresses.

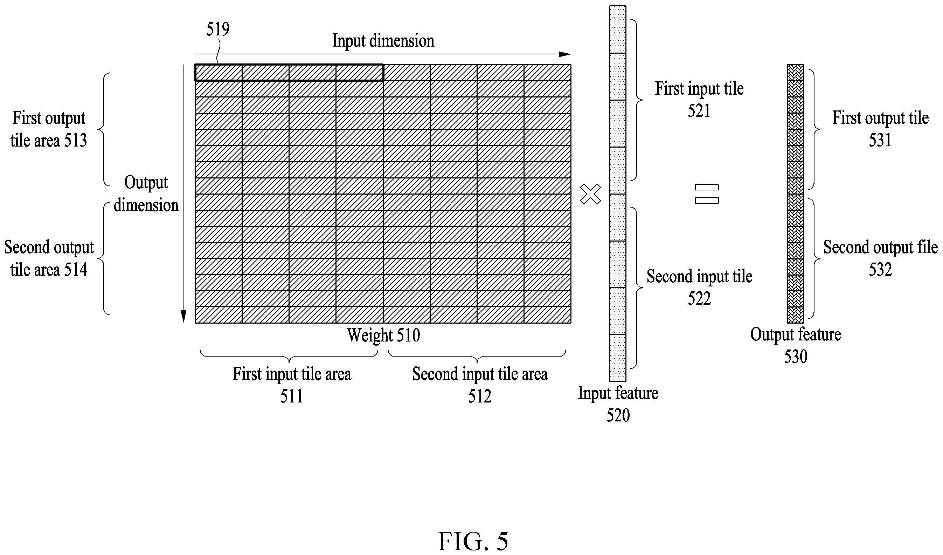

FIG. 5 is a diagram exemplarily illustrating a mapping relationship among a weight, an input feature, and an output feature, according to an embodiment. Referring to FIG. 5, an output feature 530 may be generated based by performing a MAC operation on a weight 510 and an input feature 520. The weight 510 may include weight tiles such as a weight tile 519. Each weight tile may include subtiles. FIG. 5 shows an example in which the weight tile 519 includes four subfiles, but embodiments are not limited thereto. Each subtile of the weight tile 519 may include weight elements. The number of weight elements of each subtile may correspond to the number of sub-operators of a processing unit of a memory device.

The input feature 520 may include input tiles 521 and 522. The input tiles 521 and 522 may each include subtiles. The number of subtiles of each of the input tiles 521 and 522 may be equal to the number of subtiles of each of the weight tiles. FIG. 5 shows an example in which the input feature 520 includes two input tiles 521 and 522, and the input tiles 521 and 522 each include four subtiles, but embodiments are not limited thereto. Each subtile of the input tiles 521 and 522 may include input elements. The number of input elements of each subtile may correspond to the number of sub-operators of the processing unit of the memory device.

The output feature 530 may include output tiles 531 and 532. The output tiles 531 and 532 may each include subtiles. The number of subtiles of each of the output tiles 531 and 532 may correspond to the product of the number of subtiles of each weight tile and each input tile and the number of memory banks. FIG. 5 shows an example in which the output feature 530 includes two output tiles 531 and 532, and the output tiles 531 and 532 each include eight subtiles. The example of FIG. 5 corresponds to an example in which the memory device uses two memory banks. However, the foregoing is an example, and embodiments are not limited thereto. Each subtile of the output tiles 531 and 532 may include output elements. The number of output elements of each subtile may correspond to the number of sub-operators of the processing unit of the memory device.

The weight 510 may be divided into a first input tile area 511 and a second input tile area 512 based on an input dimension. An operation may be performed on weight tiles of the first input tile area 511 and the first input tile 521, and an operation may be performed on weight tiles of the second input tile area 512 and the second input tile 522. The weight 510 may be divided into a first output tile area 513 and a second output tile area 514 based on an output dimension. A first output tile 531 may be generated based on an operation performed on weight tiles of the first output tile area 513 and the input feature 520, and a second output tile 532 may be generated based on an operation performed on weight tiles of the second output tile area 514 and the input feature 520.

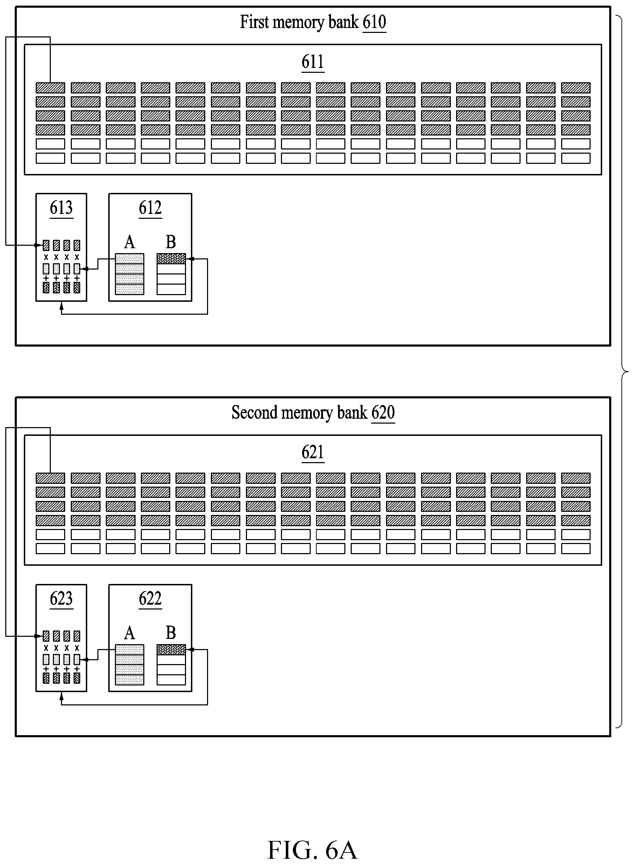

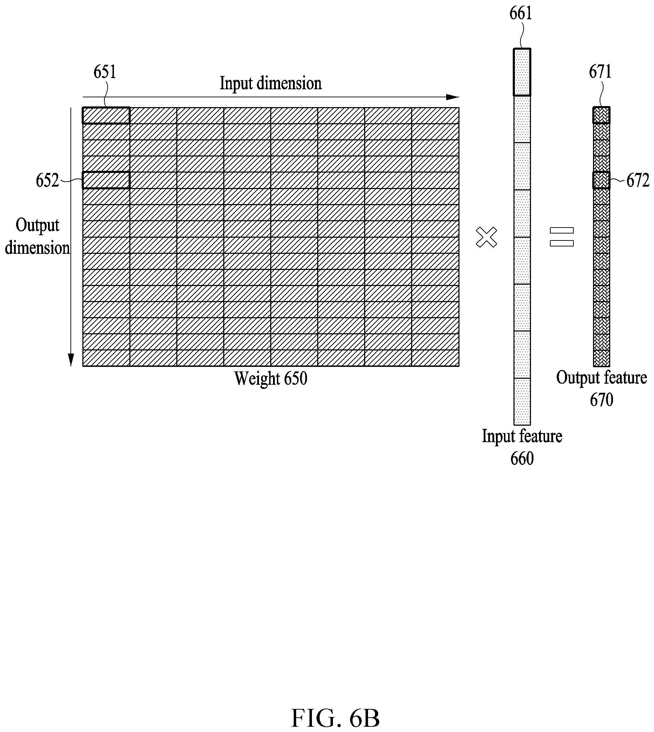

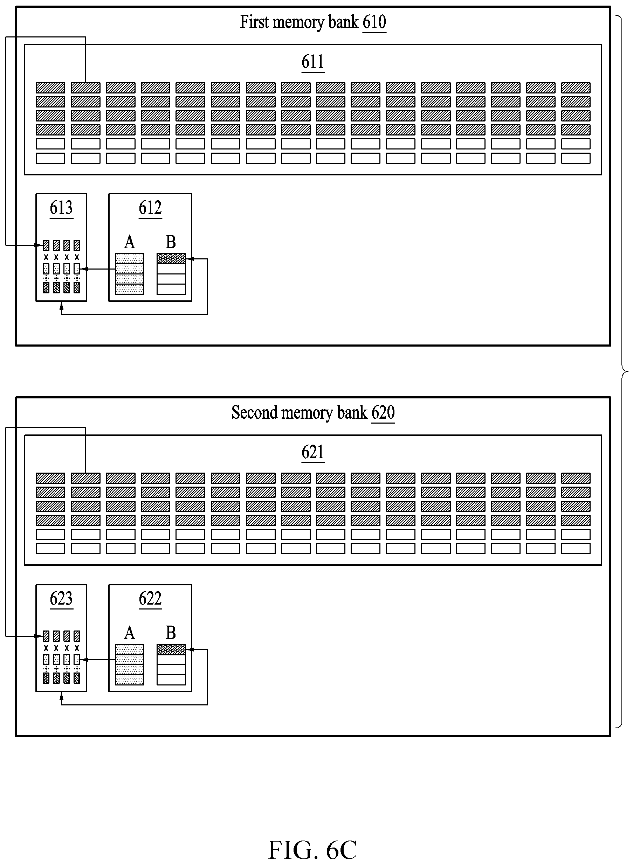

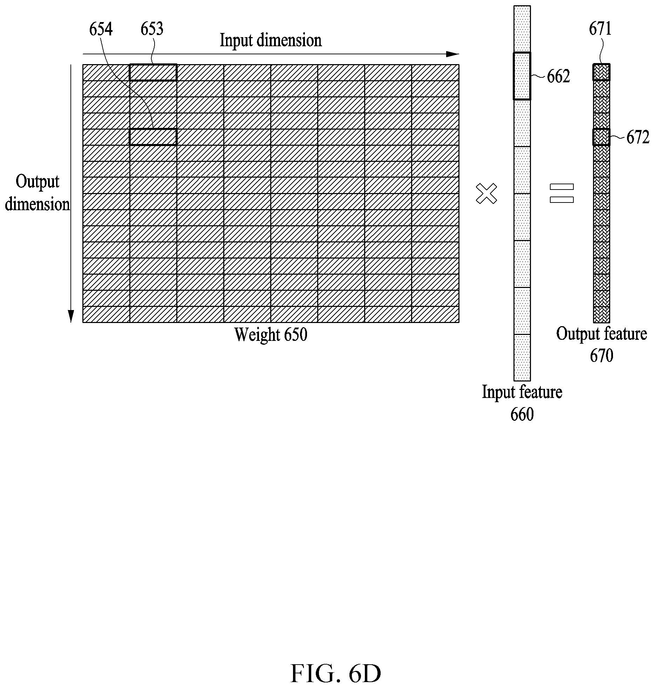

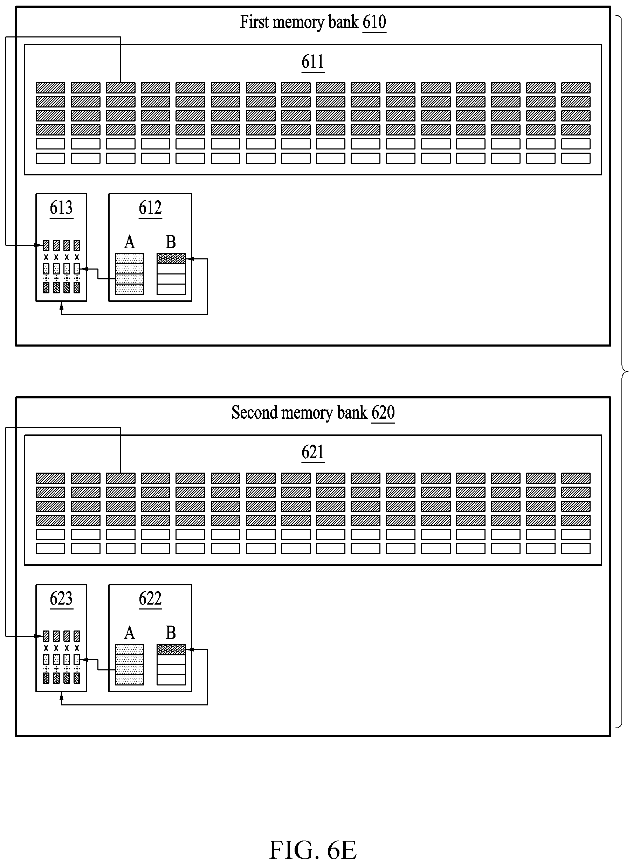

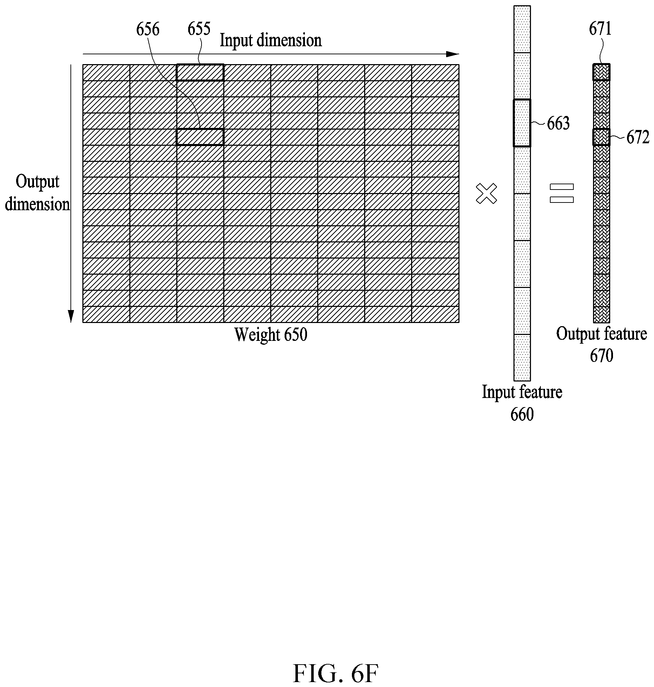

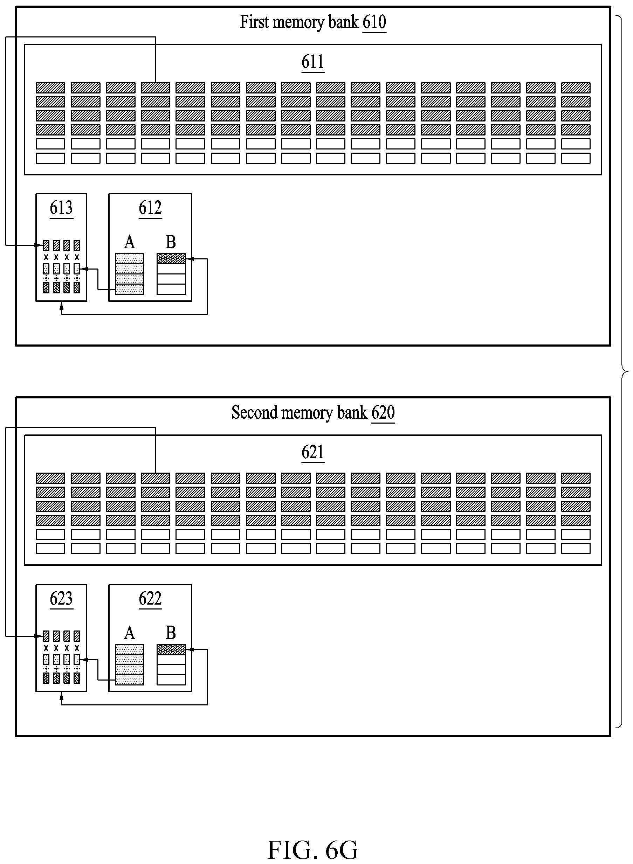

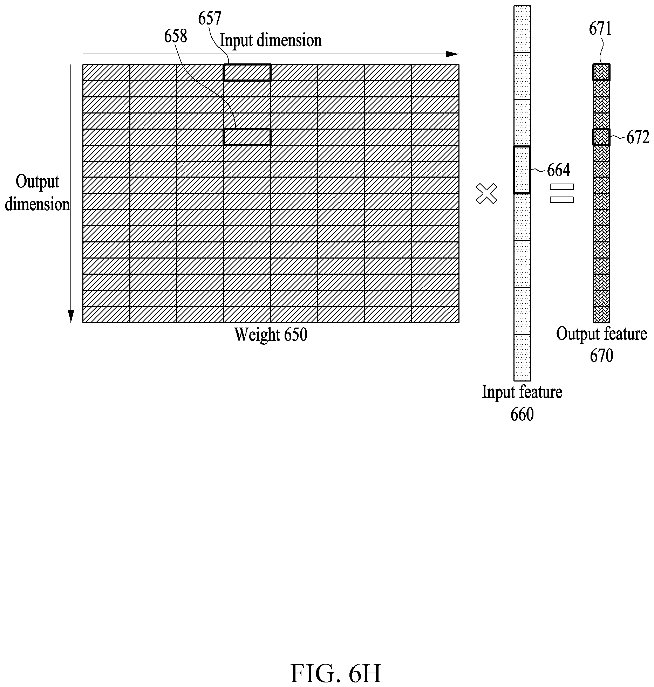

FIGS. 6A, 6C, 6E, and 6G are diagrams exemplarily illustrating a process of processing a MAC operation according to an embodiment, and FIGS. 6B, 6D, 6F, and 6H are diagrams exemplarily illustrating subtiles of a weight, an input feature, and an output feature, respectively, used in the processing process of FIGS. 6A, 6C, 6E, and 6G, according to an embodiment.

Referring to FIG. 6A, in a state in which subtiles of a first input tile of an input feature are stored in a first register group A of a data register 612 of a first memory bank 610 based on first target addresses, operations of a processing unit 613 of the first memory bank 610 may be performed. The processing unit 613 may perform operations on input elements of a first subtile of the first input tile and weight elements of a first subtile of a first weight tile of a weight loaded to a data space of the processing unit 613 based on a first address of second target addresses to generate operation results, and store the operation results in a second register group B of the data register 612. The operation results may correspond to first intermediate data of a first subtile of a first output tile of an output feature. The input elements of the first subtile of the first input tile may be loaded from a first register group A based on lower bits of the first address of the second target addresses.

The first memory bank 610 and a second memory bank 620 may operate in parallel. The first memory bank 610 may generate a portion of each output tile (e.g., first to fourth subfiles among the first to eighth subtiles of each output tile), and the second memory bank 620 may generate the remaining portion of each output tile (e.g., the fifth to eighth subtiles among the first to eighth subtiles of each output tile).

More specifically, in a state in which subtiles of a first input tile of an input feature are stored in a first register group A of a data register 622 of the second memory bank 620 based on third target addresses, operations of a processing unit 623 of the second memory bank 620 may be performed. The processing unit 623 may perform operations on input elements of a first subtile of the first input tile and weight elements of a first subtile of a second weight tile loaded to a data space of the processing unit 623 based on a first address of a fourth target address to generate operation results, and store the operation results in a second register group B of the data register 622. The operation results may correspond to first intermediate data of a fifth subtile of the first output tile of the output feature.

Referring to FIG. 6B, first intermediate data of a first subtile 671 of a first output tile of an output feature 670 may be generated based on an operation performed on a first subtile 651 of a first weight tile of a weight 650 and a first subtile 661 of a first input tile of an input feature 660, and first intermediate data of a fifth subtile 672 of the first output tile of the output feature 670 may be generated based on an operation performed on a first subtile 652 of a second weight tile of the weight 650 and the first subtile 661 of the first input tile of the input feature 660.

Referring to FIG. 6C, in a state in which the subtiles of the first input tile of the input feature are stored in the first register group A of the data register 612 of the first memory bank 610 based on the first target addresses, operations of the processing unit 613 of the first memory bank 610 may be performed continuously. The processing unit 613 may perform operations on input elements of a second subtile of the first input tile and weight elements of a second subtile of the first weight tile of the weight loaded to the data space of the processing unit 613 based on a second address of the second target addresses to generate operation results, and accumulate the operation results in first intermediate data of the first subtile of the first output tile of the output feature in the second register group B of the data register 612 to generate an accumulated result. The accumulated result may correspond to second intermediate data of the first subtile of the first output tile of the output feature. The input elements of the second subtile of the first input tile may be loaded from the first register group A based on lower bits of the second address of the second target addresses.

In a state in which the subtiles of the first input tile of the input feature are stored in the first register group A of the data register 622 of the second memory bank 620 based on the third target addresses, operations of the processing unit 623 of the second memory bank 620 may be performed. The processing unit 623 may perform operations on the input elements of the first subtile of the first input tile and weight elements of a second subtile of the second weight tile loaded to the data space of the processing unit 623 based on a second address of the fourth target address to generate operation results, and store the operation results in the second register group B of the data register 622. The operation results may be accumulated in the first intermediate data of the fifth subtile of the first output tile of the output feature in the second register group B of the data register 622 to generate an accumulated result. The accumulated result may correspond to second intermediate data of the fifth subtile of the first output tile of the output feature.

Referring to FIG. 6D, second intermediate data of the first subtile 671 of the first output tile of the output feature 670 may be generated based on an operation performed on a second subtile 653 of the first weight tile of the weight 650 and a second subtile 662 of the first input tile of the input feature 660, and second intermediate data of the fifth subtile 672 of the first output tile of the output feature 670 may be generated based on an operation performed on a second subtile 654 of the second weight tile of the weight 650 and the second subtile 662 of the first input tile of the input feature 660.

The corresponding operations of FIGS. 6A and 6C may be performed in FIGS. 6E and 6G. Referring to FIG. 6F, third intermediate data of the first subtile 671 of the first output tile of the output feature 670 may be generated based on an operation performed on a third subtile 655 of the first weight tile of the weight 650 and a third subtile 663 of the first input tile of the input feature 660, and third intermediate data of the fifth subtile 672 of the first output tile of the output feature 670 may be generated based on an operation performed on a third subtile 656 of the second weight tile of the weight 650 and the third subtile 663 of the first input tile of the input feature 660. Referring to FIG. 6H, final data of the first subtile 671 of the first output tile of the output feature 670 may be generated based on an operation performed on a fourth subtile 657 of the first weight tile of the weight 650 and a fourth subtile 664 of the first input tile of the input feature 660, and final data of the fifth subtile 672 of the first output tile of the output feature 670 may be generated based on an operation performed on a fourth subtile 658 of the second weight tile of the weight 650 and the fourth subtile 664 of the first input tile of the input feature 660.

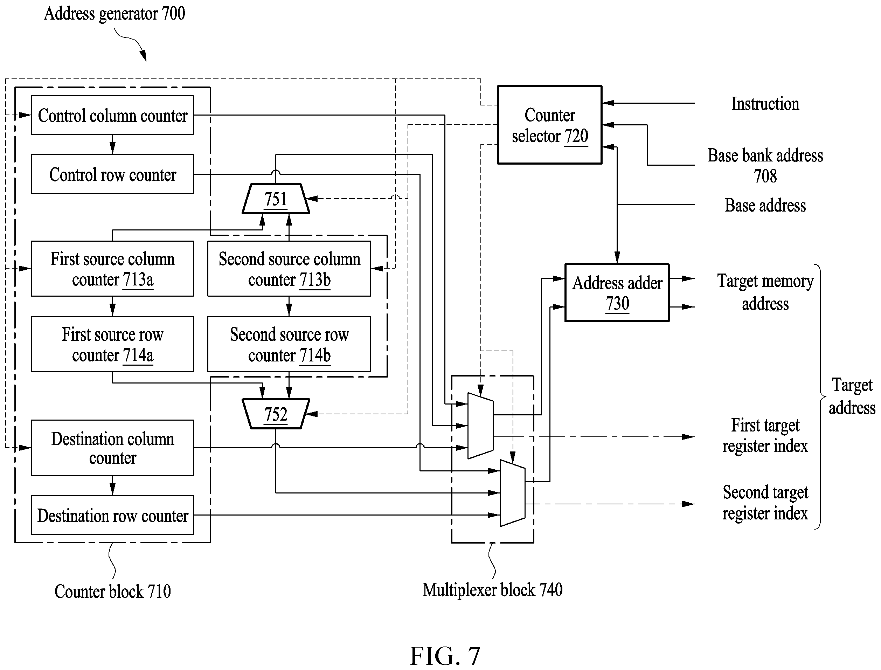

FIG. 7 is a diagram exemplarily illustrating a configuration of an address generator when memory banks share a processing-in-memory (PIM) structure, according to an embodiment. Referring to FIG. 7, an address generator 700, similar to the address generator 200 of FIG. 2A, may include a counter block 710, a counter selector 720, an address adder 730, and a multiplexer block 740. The counter block 710, the counter selector 720, the address adder 730, and the multiplexer block 740 may operate similarly to the counter block 210, the counter selector 220, the address adder 230, and the multiplexer block 240 of the address generator 200.

The counter selector 720, unlike the counter selector 220 of FIG. 2A and the counter selector 220a of FIG. 2B, further receives a base bank address 708. The base bank address 708 may include an address of one of memory banks that share a PIM structure (e.g., one or more of a controller, an address generator, a data register, and a processing unit). The counter selector 720 may selectively control one of a first source column counter 713a and a second source column counter 713b based on the base bank address 708. The counter selector 720 may select one of an output of the first source column counter 713a and an output of the second source column counter 713b by controlling a multiplexer 751 based on the base bank address 708. For example, when the base bank address 708 is a first value, the counter selector 720 may select the first source column counter 713a and when the base bank address 708 is a second value different from the first value, the counter selector 720 may select the second source column counter 713b. The first value may correspond to a first memory bank and the second value may correspond to a second memory bank.

A first source row counter 714a may operate when the count value of the first source column counter 713a increases to the maximum value, and a second source row counter 714b may operate when the count value of the second source column counter 713b increases to the maximum value. The counter selector 720 may select one of an output of the first source column counter 713a and an output of the second source column counter 713b by controlling a multiplexer 752 based on the base bank address 708. The first source column counter 713a and the first source row counter 714a may operate for the first memory bank, and the second source column counter 713b and the second source row counter 714b may operate for the second memory bank.

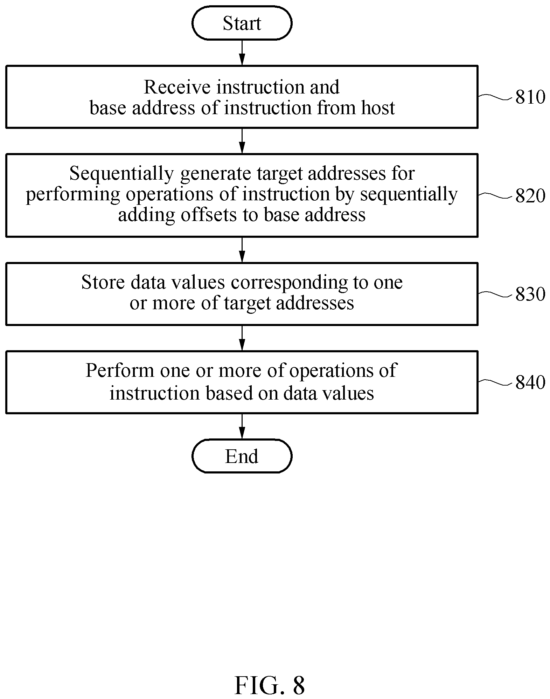

FIG. 8 is a flowchart exemplarily illustrating an operating method of a memory device, according to an embodiment. Referring to FIG. 8, the operating method includes a memory device receiving an instruction and a base address of the instruction from a host in operation 810. For example, the memory device 100 may receive instruction 101 and base address 202. The operating method of FIG. 8 further includes sequentially generating target addresses for performing operations of the instruction by sequentially adding offsets to the base address in operation 820. For example, an address generator (e.g., 200, 200a, etc.) may generate the target addresses. The operating method of FIG. 8 further includes storing data values corresponding to one or more of the target addresses in operation 830. For example, the data values could be stored in the data register 140. The operating method of FIG. 8 further includes performing one or more of the operations of the instruction based on the data values in operation 840. For example, the processing unit 150 may perform the one or more operations.

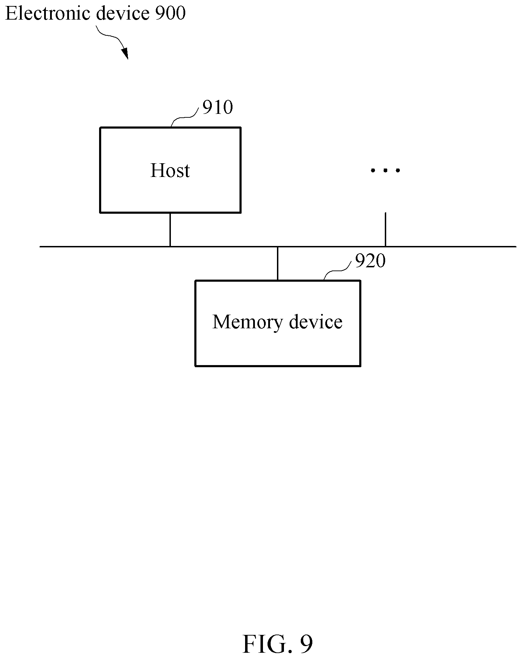

FIG. 9 is a diagram exemplarily illustrating a configuration of an electronic device, according to an embodiment. Referring to FIG. 9, an electronic device 900 may include a host 910 and a memory device 920. The electronic device 900 may further include other devices such as memory, a storage device, an input device, an output device, and a network device. Here, the memory may correspond to traditional memory that has a storage function and no computational function. For example, the electronic device 900 may be implemented as at least a part of a mobile device such as a mobile phone, a smart phone, a personal digital assistant (PDA), a netbook, a tablet computer or a laptop computer, a wearable device such as a smart watch, a smart band or smart glasses, a computing device such as a desktop or a server, a home appliance such as a television, a smart television or a refrigerator, a security device such as a door lock, or a vehicle such as an autonomous vehicle or a smart vehicle.

The host 910 may correspond to a processor such as a CPU or a GPU. The host 910 may generate an instruction and a base address and transmit the instruction and the base address to the memory device 920. The memory device 920 may include an address generator configured to receive an instruction and a base address of the instruction from the host 910 and sequentially generate target addresses for performing operations of the instruction by sequentially adding offsets to the base address, a data register configured to store data values corresponding to one or more of the target addresses, and a processing unit configured to perform one or more of the operations of the instruction based on the data values.

The units described herein may be implemented using a hardware component, a software component and/or a combination thereof. A processing device may be implemented using one or more general-purpose or special-purpose computers, such as, for example, a processor, a controller and an arithmetic logic unit (ALU), a digital signal processor (DSP), a microcomputer, a field-programmable gate array (FPGA), a programmable logic unit (PLU), a microprocessor or any other device capable of responding to and executing instructions in a defined manner. The processing device may run an operating system (OS) and one or more software applications that run on the OS. The processing device also may access, store, manipulate, process, and create data in response to execution of the software. For purpose of simplicity, the description of a processing device is used as singular; however, one skilled in the art will appreciate that a processing device may include multiple processing elements and multiple types of processing elements. For example, the processing device may include a plurality of processors, or a single processor and a single controller. In addition, different processing configurations are possible, such as parallel processors.

The software may include a computer program, a piece of code, an instruction, or some combination thereof, to independently or uniformly instruct or configure the processing device to operate as desired. Software and data may be stored in any type of machine, component, physical or virtual equipment, or computer storage medium or device capable of providing instructions or data to or being interpreted by the processing device. The software also may be distributed over network-coupled computer systems so that the software is stored and executed in a distributed fashion. The software and data may be stored by one or more non-transitory computer-readable recording mediums.

The methods according to the above-described embodiments may be recorded in non-transitory computer-readable media including program instructions to implement various operations of the above-described embodiments. The media may also include, alone or in combination with the program instructions, data files, data structures, and the like. The program instructions recorded on the media may be those specially designed and constructed for the purposes of these embodiments. Examples of non-transitory computer-readable media include magnetic media such as hard disks, floppy disks, and magnetic tape; optical media such as CD-ROM discs, DVDs, and/or Blue-ray discs; magneto-optical media such as optical discs; and hardware devices that are specially configured to store and perform program instructions, such as read-only memory (ROM), random access memory (RAM), flash memory (e.g., USB flash drives, memory cards, memory sticks, etc.), and the like. Examples of program instructions include both machine code, such as produced by a compiler, and files containing higher-level code that may be executed by the computer using an interpreter.

The above-described hardware devices may be configured to act as one or more software modules to perform the operations of the above-described examples, or vice versa.

While a number of embodiments have been described above, it should be understood that various modifications may be made to these embodiments. For example, suitable results may be achieved if the described techniques are performed in a different order and/or if components in a described system, architecture, device, or circuit are combined in a different manner and/or replaced or supplemented by other components or their equivalents. Accordingly, other implementations are within the scope of the following claims.

## Claims

1. A memory device comprising:
a memory array;
an address generator configured to receive an instruction and a base address of the instruction from a host, and sequentially generate target addresses for performing operations of the instruction by sequentially adding offsets to the base address;
a data register configured to store data values corresponding to one or more of the target addresses; and
a processing unit configured to perform one or more of the operations of the instruction based on the data values.

2. The memory device of claim 1, wherein the address generator comprises:
a counter block configured to generate the offsets;
a counter selector configured to control the counter block; and
an address adder configured to generate target memory addresses of the target addresses by adding the offsets to the base address.

3. The memory device of claim 2, wherein the counter block comprises:
a column counter group comprising a plurality of column counters; and
a row counter group comprising a plurality of row counters.

4. The memory device of claim 3, wherein
the column counter group comprises a column counter configured to sequentially increase a column count value corresponding to a column offset based on control of the counter selector, and
the row counter group comprises a row counter configured to increase a row count value corresponding to a row offset when the column count value is increased to a maximum value,
wherein the column counter is configured to initialize the column count value when the column count value is increased to the maximum value.

5. The memory device of claim 3 or 4, wherein the address generator further comprises:
a column multiplexer configured to select an output of one of the plurality of column counters based on control of the counter selector; and
a row multiplexer configured to select an output of one of the plurality of row counters based on control of the counter selector.

6. The memory device of claim 5, wherein the column multiplexer and the row multiplexer are configured to output the target memory addresses or target register indexes as the target addresses based on at least one of the instruction and the base address.

7. The memory device of claim 6, wherein the target register indexes are generated by extracting a number of bits that identify a number of registers in each register group of the data register from a least significant bit, LSB, of the output of the counter block.

8. The memory device of one of claims 2 to 7, wherein
the counter selector is configured to receive a first instruction for storing subtiles of a first input feature tile of an input feature in a first register group of the data register and a first base address of the first instruction indicating a starting index of the first register group, and control the counter block to generate offsets of the first base address,
the address adder is configured to generate first target addresses of the first register group by adding the offsets of the first base address to the first base address, and
the first register group is configured to store the subtiles of the first input feature tile in the first register group based on the first target addresses.

9. The memory device of claim 8, wherein the subtiles of the first input feature tile are stored in the first register group by the first instruction without the host performing an operation to calculate the offsets of the first base address.

10. The memory device of claim 8 or 9, wherein
the counter selector is configured to receive a second instruction for storing subtiles of a first weight tile of a weight in a data space of the processing unit and a second base address of the second instruction indicating a starting address of the memory array in which the weight is stored, and control the counter block to generate offsets of the second base address,
the address adder is configured to generate second target addresses of the memory array by adding the offsets of the second base address to the second base address, and
the processing unit is configured to sequentially perform operations on the subtiles of the first weight tile loaded to the data space of the processing unit based on the second target addresses and the subtiles of the first input feature tile loaded to the data space of the processing unit based on the first target addresses to generate operation results, and generate subtiles of a first output feature tile by accumulating the operation results.

11. The memory device of claim 10, wherein the operations on the subtiles of the first weight tile and the subtiles of the first input feature tile are performed by the second instruction without an operation by the host to calculate the offsets of the second base address.

12. The memory device of claim 10 or 11, wherein
the counter selector is configured to receive a third instruction for storing, in the memory array, subtiles of the first output feature tile stored in a second register group of the data register, and a third base address of the third instruction indicating a starting address of the memory array to store the subtiles of the first output feature tile, and control the counter block to generate offsets of the third base address,
the address adder is configured to generate third target addresses of the memory array by adding the offsets of the third base address to the third base address, and
the subtiles of the first output feature tile are stored in the memory array based on the third target addresses,
wherein the subtiles of the first output feature tile are stored in the memory array by the third instruction without the host performing an operation to calculate the offsets of the third base address.

13. The memory device of one of claims 1 to 12, wherein the offsets have a predetermined interval.

14. An electronic device comprising:
a host; and
a memory device according to one of claims 1 to 13,
wherein the address generator is configured to receive the instruction and the base address of the instruction from the host.

15. An operating method of a memory device, the operating method comprising:
receiving an instruction and a base address of the instruction from a host;
sequentially generating target addresses for performing operations of the instruction by sequentially adding offsets to the base address;
storing data values corresponding to one or more of the target addresses; and
performing one or more of the operations of the instruction based on the data values.
